Europäisches Patentamt

European Patent Office

Office européen des brevets

(11) Veröffentlichungsnummer: **0 017 021**
**B1**

(12) **EUROPÄISCHE PATENTSCHRIFT**

(45) Veröffentlichungstag der Patentschrift: **13.07.83**

(21) Anmeldenummer: **80101236.0**

(22) Anmeldetag: **11.03.80**

(51) Int. Cl.³: **H 01 L 29/72,**
**H 01 L 29/08,**
**H 01 L 29/40,**
**H 01 L 29/52,**
**H 01 L 29/56, H 01 L 27/08**

(54) Verfahren zur Herstellung einer Halbleiteranordnung mit komplementären Transistoren.

(30) Priorität: **30.03.79 US 25693**

(43) Veröffentlichungstag der Anmeldung:
**15.10.80 Patentblatt 80/21**

(45) Bekanntmachung des Hinweises auf die Patenterteilung:
**13.07.83 Patentblatt 83/28**

(84) Benannte Vertragsstaaten:
**DE FR GB**

(56) Entgegenhaltungen:
**EP - A - 0 000 743**
**FR - A - 2 111 761**
**US - A - 3 280 391**
**US - A - 3 995 301**
**IBM TECHNICAL DISCLOSURE BULLETIN, Band
20, Nr. 12, Mai 1978, New York, US, D. GITTLE-
MAN et al.: "Metal emitter PNP cell", Seiten
5190—5191**
**SOLID STATE ELECTRONICS, Band 12, Nr. 3,
März 1969, Pergamon Press, London, GB,
A.Y.C. YU et al.: "Minority carrier injection of
metal-silicon contacts", Seiten 155—160**

(73) Patentinhaber: **International Business Machines
Corporation
Old Orchard Road
Armonk, N.Y. 10504 (US)**

(72) Erfinder: **De Bar, David E.
13001 Wooded Acres Ct.
Manassas, Va. 22110 (US)**
Erfinder: **Hamaker, Raymond W.
1560 Welburn Ave.
Gilroy, California 95020 (US)**
Erfinder: **Stephens, Geoffrey B.
1320 Yubinaranda Circle
Cary, North Carolina 27511 (US)**

(74) Vertreter: **Gaugel, Heinz, Dipl.-Ing.
Schönaicher Strasse 220
D-7030 Böblingen (DE)**

(56) Entgegenhaltungen:
**IBM TECHNICAL DISCLOSURE BULLETIN, Band
21, Nr. 1, Juni 1978, New York, US, T. M. REITH
et al.: "Al-like Schottky barrier diode formation
using Ti-W", Seiten 142—143**
**PATENT ABSTRACTS OF JAPAN, Band 1, Nr.
150, 5 Dezember 1977, Tokyo, JP**

Verfahren zur Herstellung einer Halbleiteranordnung mit komplementären Transistoren

Die Erfindung betrifft ein Verfahren zur Herstellung einer Halbleiteranordnung mit komplementären Transistoren entsprechend dem Oberbegriff des Patentanspruchs 1.

Auf dem Gebiet der elektrischen Schaltkreistechnik hat sich weithin die Erkenntnis durchgesetzt, daß man mit komplementären Bipolartransistoren vorteilhafte Betriebseigenschaften erzielen kann, da man z.B. in einem Inverter-Grundschaltkreis zu einem aktiven NPN Bipolartransistor einen dazu komplementären PNP Bipolartransistor als ebenfalls aktives Lastelement einsetzen kann. Problematisch ist jedoch an komplementären Bipolarschaltkreisen, daß ihre Herstellung auf einem gemeinsamen integrierten Schaltungsplättchen im allgemeinen eine komplexere Verfahrensausgestaltung erfordert als bei Vorsehung von Transistoren nur eines Leitungstyps. Es wurden auch bereits komplementäre Bipolartransistorstrukturen mit einem vertikalen NPN und einem lateralen PNP Transistor untersucht und aufgebaut. Die zu deren Herstellung entwickelten Prozesse konnten auch einfacher ausgelegt werden als für eine gemeinsame Integration von vertikalen PNP und NPN Transistoren. Häufig wirkte jedoch als nachteilig, daß die Betriebs- bzw. Schalteigenschaften lateraler PNP Bipolartransistoren nicht annähernd so gut sind wie die im gleichen Prozeß herstellbaren NPN Transistoren. Weiterhin ist zu berücksichtigen, daß ein lateral aufgebauter PNP Transistor einen größeren Platzbedarf hat als ein einfacher vertikal aufgebauter PNP Transistor.

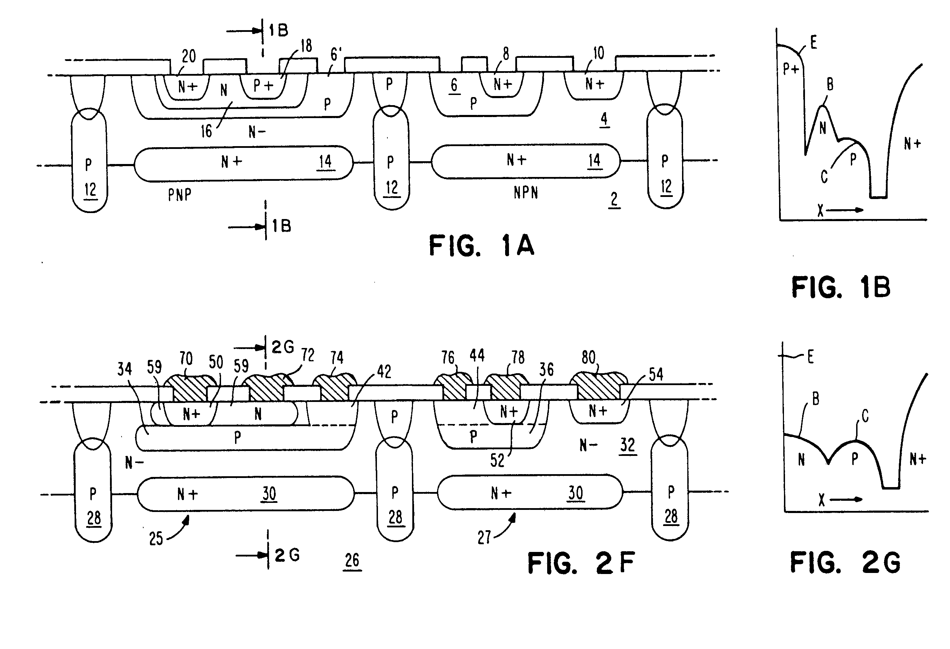

Es wurde auch bereits eine in Fig. 1A dargestellte Halbleiteranordnung vorgeschlagen, in der innerhalb eines Basisgebiets vom P Leitungstyp in einer Struktur, die ansonsten einen vertikalen NPN Transistor ergäbe, ein lateraler PNP Bipolartransistor gebildet wird. Wie in Fig. 1A gezeigt ist, wird ein konventioneller NPN Bipolartransistor in einer Epitaxieschicht 4 auf dem mit 2 bezeichnenden Substrat durch Einbringen eines P Basisgebiets 6 gebildet, in das ein N Emittergebiet 8 eingebracht wird. Weiterhin ist ein Kollektoranschlußgebiet 10 als Verbindung zur Epitaxieschicht vorgesehen. Im Rahmen eines solchen Aufbaus können ferner Isolationsgebiete 12 vom P Leitungstyp sowie Subkollektorgebiete 14 vom N+ Leitungstyp hinzukommen. Gemeinsam damit ist auf demselben Substrat 2 ein weiteres mit 6' bezeichnetes P Gebiet angeordnet, das ansonsten das Basisgebiet eines vertikal aufgebauten NPN Transistors darstellen würde, das jedoch in diesem Fall als Kollektorgebiet eines vertikal ausgebildeten PNP Bipolartransistors dient. In einer solchen Struktur wird in dem P Kollektorgebiet 6' ein N Basisgebiet 16 erzeugt, und in letzterem wiederum ein flaches P Emittergebiet 18 angeordnet. Als Basisanschlußgebiet 20 kann ferner in das Basisgebiet 16 noch ein entsprechendes N+ Gebiet 20 eingebracht werden. Der daraus resultierende Aufbau eines PNP Transistors ist herstellungsmäßig mit einem Prozeß zum Aufbau von vertikalen NPN Transistoren kompatibel. Aufgrund des relativ großen Kollektor-Serienwiderstandes sowie der relativ geringen Durchbruchspannung zwischen Kollektor 6' und Basis 16 infolge der Notwendigkeit zur Kompensierung von vier übereinanderliegenden Dotierungsgebieten treten bei einem so aufgebauten PNP Bipolartransistor jedoch erhebliche mit dem Schaltverhalten zusammenhängende Probleme auf. Die überaus hohe Dotierungskonzentration im Basisgebiet 16 sowie im Emittergebiet 18 bringen erhebliche Gitterstörungen mit sich, wodurch die Beweglichkeit der Minoritätsträger reduziert wird, die vom Emitter in den Basisbereich injiziert werden, und die in einer erhöhten Rekombinationsrate der Minoritätsträger im Basisgebiet resultieren.

Aus der Veröffentlichung "IBM Technical Disclosure Bulletin" Vol. 20, No. 12, May 1978, Seiten 5190 und 5191 ist eine Speicherzelle bekannt, die zwei teilweise verschmolzene komplementäre Transistoren enthält und zu deren Herstellung Verfahrensschritte anwendbar sind, wie sie im ersten Teil des Anspruchs angegeben sind.

Die Erfindung, wie sie in den Patentansprüchen gekennzeichnet ist, löst nun die Aufgabe, ein Verfahren zur Herstellung komplementärer Transistoren anzugeben, bei dem in einem einfachen NPN Bipolarprozeß sowohl der NPN Transistor als auch der PNP Transistor einschließlich ihrer Anschlußzonen verwirklichbar und hervorragende Betriebseigenschaften der erhaltenen Strukturen erreichbar sind.

Die mit der Erfindung erzielbaren Vorteile bestehen hinsichtlich der verbesserten Betriebseigenschaften der so hergestellten Transistoren darin, daß sich geringere Werte für den Kollektorserienwiderstand, die Emitter/Basis- sowie die Kollektor/Basis-Kapazitäten sowie die Basisweite erzielen lassen. Vorteilhafte höhere Werte lassen sich erreichen für die Integrationsdichte, die Schaltgeschwindigkeit, die Kollektor/Basis-Durchbruchspannung sowie für die Löcherbeweglichkeit aufgrund geringer Gitterstörungen in der Basiszone.

Die Erfindung wird im folgenden anhand von Ausführungsbeispielen unter Zuhilfenahme der Zeichnungen näher erläutert.

Es zeigen:

Fign. 1A und 1B eine Querschnittsdarstellung für einen vertikalen PNP Bipolartransistor sowie ein zugehöriges Dotierungsprofil entlang der angegebenen Schnittlinie;

Fig. 2A bis 2F entsprechende Querschnittsdarstellungen zur Erläuterung der Verfahrensschritte zur Ausbildung der Erfindung;

Fig. 2G die Darstellung eines zugehörigen Dotierungsprofils entlang der in Fig. 2F angegebenen Schnittlinie;

Fig. 3 eine Darstellung im Bändermodell zur Illustration der physikalischen Zusammenhänge bei einer Löcherinjektion mittels eines Schottky-Kontakts als Emitter;

Fig. 4 ein weiteres Ausführungsbeispiel einer vertikalen PNP-Struktur mit einer Schottky-Diode als Emitter, bei dem das (früher ionenimplantierte) Basisgebiet 59' durch die Epitaxieschicht 4 ersetzt ist;

Fign. 5A und 5B einen Querschnitt sowie ein Schaltbild durch eine in Bipolartechnik aufgebaute dynamische Schreib-/Lesespeicherzelle, die eine solche vertikale PNP Struktur mit einer Schottky-Diode als Emitter verwendet und

Fig. 5C eine Querschnittsdarstellung einer die Erfindung einsetzenden integrierten Injektionslogikschaltung.

Es ist weiterhin bekannt, daß eine Schottky-Diode, obwohl in erster Linie ein Majoritätsträger-Bauelement, Minoritätsträger injizieren kann, wenn sie bei genügend hohen Stromdichten betrieben wird, vgl. D. L. Scharfetter in "Solid-State Electronics", Pergamon Press 1965, Vol. 8, Seiten 299 bis 311. Obwohl diese Eigenschaft normalerweise unerwünscht ist, wenn man nämlich die Schottky-Diode zur Verringerung der Minoritätsträgerspeicherung in der Nähe eines Kollektor-Basisübergangs als sog. "clamp" einsetzt, läßt sich diese Eigenschaft bei der Erfindung vorteilhaft ausnutzen.

Im Rahmen der Erfindung wird der Emitter eines PNP Transistors als Schottky-Kontakt ausgebildet, so daß bis zur Tiefe des NPN Emitterübergangs lediglich das PNP Basisgebiet untergebracht werden muß, vgl. Fig. 2F. Da ferner bei dem hier vorgeschlagenen Strukturaufbau eine separate, maskierte Ionenimplantation für die Dotierung der intrinsischen NPN Basis (die gleichzeitig das PNP Kollektorgebiet bildet) durchgeführt wird, kann das Dotierungsprofil der PNP Basis das entsprechende PNP Kollektor-Dotierungsprofil bei geringeren Konzentrationswerten abschneiden, woraus geringere Werte für die Kollektor/Basis-Kapazität, den Kollektor-Serienwiderstand sowie höhere Werte für die Kollektor/Basis-Durchbruchspannung des PNP Transistors resultieren. Aufgrund der geringeren Basis-Dotierungskonzentration sowie der Tatsache, daß der Emitter keine seitlichen Flächen aufweist, wird überdies die PNP Emitter/Basis-Kapazität erheblich reduziert. Daraus resultiert ein verbesserter Frequenzgang der so aufgebauten PNP Struktur.

Fig. 1A zeigt einen konventionellen vertikalen PNP Aufbau; Fig. 1B zeigt ein zugehöriges Dotierungsprofil entlang der in Fig. 1A gezeigten Schnittlinie. Eine N Epitaxieschicht 4 ist dabei auf der Oberfläche eines Siliciumsubstrats 2 aufgewachsen, in dem vergrabene P Isolationsgebiete 12 sowie N+ Subkollektorgebiete 14 angeordnet sind. In die Oberfläche der Epitaxieschicht 4 sind Basis-Dotierungsgebiete 6 und 6' vom P Leitungstyp eingebracht. Das vertikale NPN Bauelement wird dann fertiggestellt, indem die Dotierungsgebiete 8 und 10 für Emitter und Kollektoranschluß in der in Fig. 1A gezeigten Weise eingebracht werden. Im selben Verfahrensschritt wird das Basis-Anschlußgebiet 20 für das vertikale PNP Bauelement ausgebildet, woran sich die Bildung des N Basisgebiets 16 anschließt, wozu ein im Vergleich zu dem Dotierungsstoff für das Basis-Anschlußgebiet 20, z.B. Arsen, schneller diffundierendes Dotierungsmittel vom N Leitungstyp benutzt werden kann. Abgeschlossen wird der Aufbau des konventionellen vertikalen PNP Bauelements durch Diffusion des Emitters 18 vom P+ Leitungstyp in das N Basisgebiet 16.

Festzuhalten ist in diesem Zusammenhang, daß die zusätzliche Vorsehung eines vertikalen PNP Bauelements in einem konventionellen NPN Herstellungsprozeß eine Reihe zusätzlicher Verfahrensschritte erfordert und den insgesamten Herstellungsgang unerwünscht komplex macht.

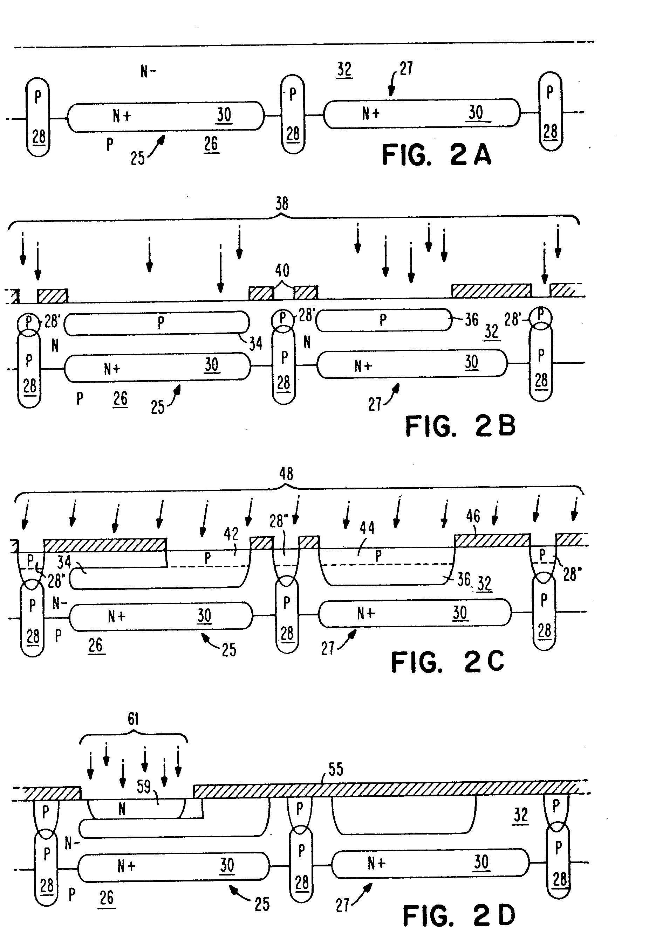

Unter Bezugnahme auf die Fign. 2A bis 2F wird nun die Herstellung eines vertikalen PNP Aufbaus mit einer Schottky-Diode als Emitter erläutert. Der Herstellungsprozeß beginnt (Fig. 2A) mit dem Aufbringen einer Silicium-Epitaxieschicht 32 vom N— Leitungstyp auf die Oberfläche des mit 26 bezeichneten Siliciumsubstrats, wobei gleichzeitig die Isolationsgebiete 28 vom P Leitungstyp sowie die Subkollektorgebiete 30 vom N+ Leitungstyp ausgebildet werden. Fig. 2B zeigt im nächsten Verfahrensschritt die Bildung einer Ionenimplantationsmaske 40, die beispielsweise aus gehärtetem Photolack bestehen kann, sowie die Implantation von beispielsweise Borionen 38, wodurch die vergrabenen P Gebiete 34 und 36 sowie die mit 28' bezeichneten Isolations-Verlängerungsgebiete gebildet werden, die alle vom P Leitungstyp sind. Das mit 34 bezeichnete implantierte Gebiet wird schließlich einen Teil des P Kollektors des vertikalen PNP Transistors 25 und entsprechend das mit 36 bezeichnete implantierte Gebiet vom P Leitungstyp einen Teil der P Basis für das NPN Bauelement 27 bilden.

Entsprechend Fig. 2C wird im nächsten Verfahrensschritt unter Anwendung einer zweiten Implantationsmaske 46, z.B. wiederum aus gehärtetem Photolack, eine zweite Borimplantation 48 durchgeführt, um die an die Oberfläche reichenden Teile der Isolationsgebiete 28", des P Kollektors 42 für das PNP Bauelement 25 sowie des oberen Teils 44 der P Basis für den NPN Transistor 27 auszubilden.

Anhand von Fig. 2D ist illustriert, wie mit Hilfe einer dritten, beispielsweise wiederum aus gehärtetem Photolack bestehenden Implantationsmaske 55 Dotierstoffe vom N Leitungstyp, z.B. Phosphorionen 61, zur Bildung des mit 59 bezeichneten Basisgebiets vom N Leitungstyps für das vertikale PNP Bauelement eingebracht werden.

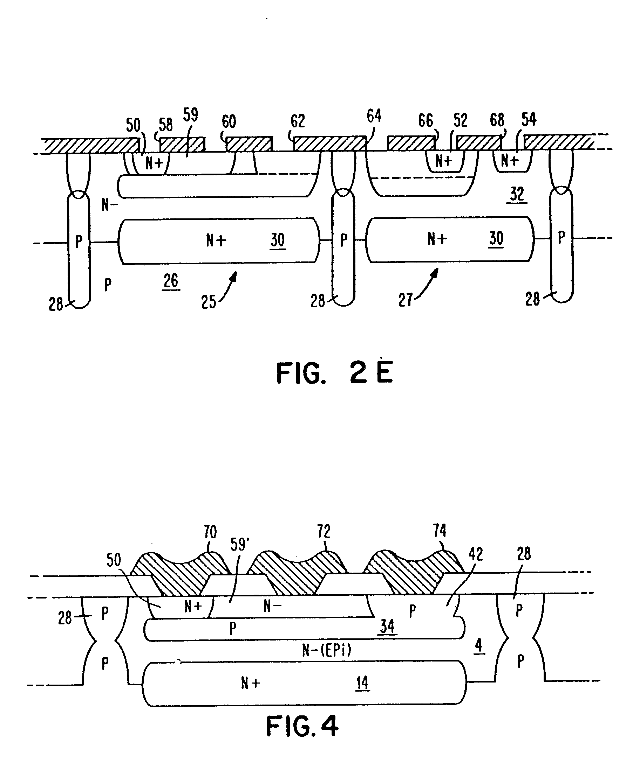

Entsprechend Fig. 2E wird im nächsten Verfahrensschritt eine weitere Implantationsmaske, z.B. aus gehärtetem Photolack, mit den darin befindlichen Öffnungen 58, 60, 62, 64, 66 und 68 gebildet. In Gegenwart einer selektiven Abdeckung der Öffnungen 60, 62 und 64 kann eine Ionenimplantation, z.B. mit Arsenionen, durchgeführt werden, um das N+ Basis-Anschlußgebiet 50 für das vertikale PNP Bauelement 25, den N+ Emitter 52 des vertikalen NPN Bauelements ·27 sowie dessen N+ Kollektoranschlußgebiet 54 herzustellen. Die gegen die Ionenimplantation wirksamen Abdeckungen im Bereich der Öffnungen 60, ˙62 und 64 können anschließend entfernt und durch eine Schicht aus Metall, z.B. Aluminium, ersetzt werden, wodurch die Basis-Elektrode 70 für das vertikale PNP Bauelement 25, dessen Schottky-Emitter 72 sowie dessen Kollektorelektrode 74 gebildet werden. Die genannte Metallschicht bildet ferner den elektrischen Kontakt 76 für die Basis 44, den Kontakt 78 für den Emitter 52 sowie den Kollektorkontakt 80 für die Epitaxieschicht 32 im Rahmen des vertikalen NPN Bauelements 27. Die endgültig erhaltene Struktur mit einem vertikalen PNP Transistor mit einer Schottky-Diode als Emitter ist in Fig. 2F gezeigt.

In Fig. 2G ist die relative Konzentrationsverteilung in Form eines Dotierungsprofils entlang der in Fig. 2F gezeigten Schnittlinie angedeutet.

Der Emitter des PNP Bauelements 25 wird demnach durch einen Schottky-Diodenkontakt 72 zum Basisgebiet 59 vom N Leitungstyp gebildet, wozu ein eine entsprechende Diffusionsbarriere erzeugendes Metall-/Halbleitersystem verwendet wird. Ein solches Schottkykontakt-Metallsystem sollte weder Silicium aus dem Basisgebiet 59 des PNP Bauelements 25 herausnehmen noch zu sehr in das Siliciumsubstrat eindringen. Im folgenden sind die wesentlichen Anforderungen an diesen Emitterkontakt 72 wiedergegeben, damit er eine effektive Löcherinjektion in das N Basisgebiet 59 leisten kann.

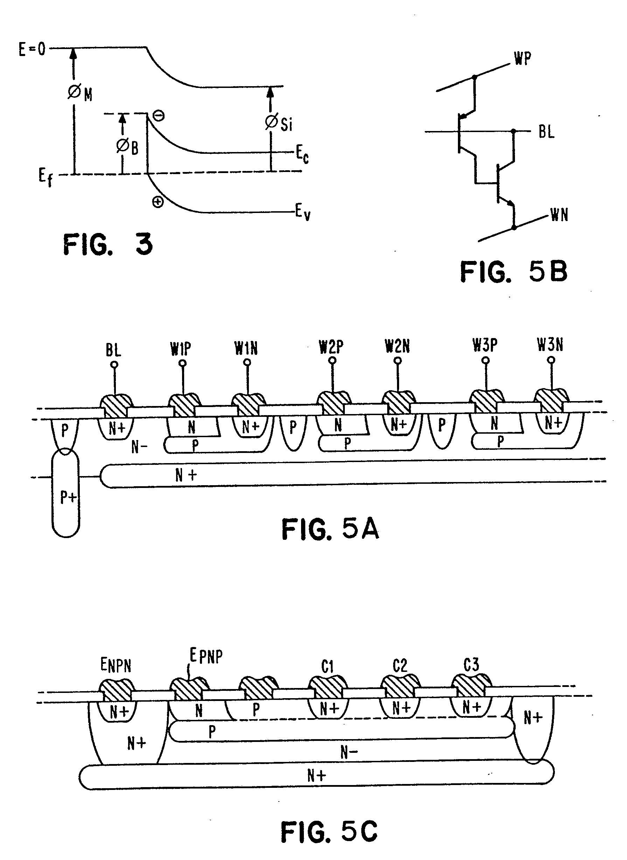

Das Kontaktmetallsystem sollte aus einer Gruppe von Metallen und/oder Metallegierungen in einer Weise gewählt werden, daß ein Minimum an Reaktionsvermögen zwischen dem Metallsystem und dem Silicium bei oder unterhalb der Kontakt-Sintertemperatur besteht. Der Wert für die Austrittsarbeit des Kontaktmetalls sollte größer sein als der entsprechende Wert für das Basisgebiet vom N Leitungstyp, um die richtige Bandverbiegung in der Nähe der Metall-/Siliciumgrenzschicht zu gewährleisten (vgl. Fig. 3). Der Wert für die Austrittsarbeit des Kontaktmetallsystems sollte ferner groß genug sein, um eine genügende Löcherkonzentration (d.h. eine Inversionsschicht) an der Metall-/Siliciumgrenzschicht zu garantieren. Aus der eingangs genannten Literatur ergibt sich als Abschätzung, daß ein Wert der Austrittsarbeit von ungefähr 4,8 eV oder größer eine ausreichend hohe Schottky-Barriere zur Erfüllung dieser Bedingungen gewährleistet.

Das Kontaktmetall sollte den freigelegten Kontaktbereich vollständig und möglichst mit einer geringen Überlappung der die Struktur schützenden dielektrischen Passivierungsschicht bedecken. Dadurch wird sichergestellt, daß nicht nach Betriebsaufnahme schädliche Verschiebungen der elektrischen Betriebseigenschaften verursacht werden, die auf Randeffekten infolge unbedeckter Kontaktflächen beruhen.

Obwohl eine Schottky-Diode ein Majoritätsträger injizierendes Bauelement ist, kann unter bestimmten Umständen auch eine Minoritätsträgerinjektion stattfinden. Diese ist normalerweise unerwünscht; sie kann jedoch nützlich sein, wenn man ein solches Bauelement als Emitter eines PNP Transistoraufbaus 25 einsetzen möchte. Für eine geeignete PNP Konfiguration sollte die Metallegierung für den Schottky-Diodenkontakt einen höheren Wert für die Austrittsarbeit haben also das Siliciumsubstrat, um die richtige Bandverbiegung in der Nähe der Metall-/Siliciumgrenzschicht zu gewährleisten. Dies soll anhand von Fig. 3 erläutert werden, in der ein eindimensionales Bändermodell der Grenzschicht zwischen dem Metall und dem Silicium vom N Leitungstyp gezeigt ist. Mi $\phi_B$ ist die resultierende Schottky-Barrierenspannung bezeichnet. Bei dieser Art von Anordnung sollte die Austrittsarbeit des Metalls ($\phi_M$) deutlich größer sein als die des Siliciums ($\phi_{Si}$), um eine angemessene Löcherkonzentration in der Oberflächen-Inversionsschicht des Schottky-Emitters zu gewährleisten. Die Basis eines solchen Bauelements ist im allgemeinen eine Epitaxieschicht, wie z.B. die mit 32 bezeichnete Schicht vom N Leitungstyp, während es sich bei dem mit 34 bezeichneten Kollektor entweder um eine tiefe Implantation vom P Leitungstyp oder um ein vergrabenes Diffusionsgebiet, wie z.B. für die Isolationsschicht am Boden, handelt. Soll ein solcher Kollektor 34 vom Substrat isoliert werden, wäre ein tiefes Implantationsgebiet der wirksamste Kollektortyp. Eine Epitaxieschicht vom P Leitungstyp kann ebenfalls für diesen Zweck verwendet werden, was jedoch verhältnismäßig schwierig mit einem standardmäßig ausgestalteten bipolaren Herstellungsverfahren zu vereinbaren wäre.

Anhand der Fig. 4 soll eine mögliche alternative Version eines vertikalen PNP Bauelements, entsprechend dem bisher beschriebenen Bauelement 25 mit einem Schottky-Kontakt als Emitter aufgezeigt werden. In Fig. 4 handelt es sich bei dem mit 59' bezeichneten Basisgebiet um die N-Typ Epitaxieschicht 4 selbst, die in diesem Fall ein früher (Fig. 2F) dazu vorgesehenes ionenimplantiertes Gebiet 59 vom N-Typ ersetzt. Alle übrigen Elemente in Fig. 4 sind die gleichen wie in der vertikalen PNP Bauelementstruktur 25 von Fig. 2F.

In Fig. 5A ist eine bipolare dynamische Schreib-/Lesespeicherzelle in ihrem Halbleiteraufbau und in Fig. 5B in ihrem zugehörigen Ersatzschaltbild gezeigt, in der solche vertikalen PNP-Transistoren mit einer Schottky-Diode als Emitter eingesetzt sind. Fig. 5C zeigt schließlich den Aufbau einer integrierten Injektionslogikschaltung auf der Grundlage einer Struktur der in Fig. 5A gezeigten Art, in der ebenfalls das vorgeschlagene vertikale PNP Bauelement mit einer Schottky-Diode als Emitter eingesetzt ist.

Zur Theorie hinsichtlich der Transistorverstärkung eines vertikalen PNP Bauelements mit einer Schottky-Diode als Emitter erscheinen die folgenden Ausführungen zweckmäßig.

Für die Verstärkung eines Bipolartransistors gilt die folgende grundlegende Beziehung:

$$a = g_o \cdot B^* \cdot a^*$$

dabei bedeutet

a = Stromverstärkung in Basisschaltung,
$g_o$ = Emitterergiebigkeit
b* = Basistransportfaktor
a* = Kollektormultiplikationsfaktor.

Zum besseren Verständnis der theoretischen Grundlagen für den Betrieb der vorgeschlagenen Anordnung soll auf die für die Löcherinjektionsergiebigkeit eines Schottky-Dioden-Emitterübergangs geltenden Beziehung näher eingegangen werden. Es gilt:

$$g_o = e \cdot D_p n_i^2 / N_D \cdot L \cdot J_s$$

da a proportional zu $g_o$ ist, wird sich durch Zunahme von $g_o$ auf etwa 1 die Stromverstärkung ebenfalls (bei B*, a* $\simeq$ 1) dem Wert 1 nähern.

Die hauptsächlichen Optimierungsparameter für eine hier behandelte PNP Struktur mit einer Schottky-Diode sind $D_p$, $N_D$, L und $J_s$. Der erste Parameter $D_p$ ist ein Maß für die Löcher-Diffusionskonstante im Basisgebiet und ist direkt proportional zur Löcherbeweglichkeit. Von daher sollte die Löcherbeweglichkeit im Basisgebiet möglichst maximiert werden. Das kann durch Verringerung sowohl der Dotierungs- wie auch der Defektkonzentration in dem betreffenden Gebiet zur Minimierung der Streuzentren für die Defektelektronen erreicht werden.

Für einen optimalen Wert für $g_o$ sollten insbesondere die letzteren drei der obengenannten Parameter ($N_D$, L und $J_s$) minimal gemacht werden:

1) $N_D$ ist die Basis-Verunreinigungskonzentration, die ebenfalls den Parameter $D_p$ beeinflußt.
2) L ist die Basisweite, die zum Zwecke einer hohen Kollektionsrate bezüglich der injizierten Ladungsträger verringert werden sollte.
3) $J_s$ bedeutet für die Schottky-Diode den Koeffizienten für die Elektronenstromdichte, die zur Gewährleistung einer möglichst hohen Löcherinjektion an der Metall-/Halbleiter(Emitter)grenzfläche möglichst klein gehalten werden sollte. $J_s$ nimmt mit Zunahme der Barrierenhöhe $\phi_B$ ab; von daher ist ein hoher Wert für die Austrittsarbeit des Metallkontakts an der emitterseitigen Emittergrenzfläche wesentlich, um eine genügende Bänderverbiegung zur Unterstützung einer hohen Löcherkonzentration zu garantieren.

## Patentansprüche

1. Verfahren zur Herstellung einer Halbleiteranordung mit komplementären Transistoren in einem Silicium-Halbleitermaterial des N Leitungstyps, wobei in einem Ionenimplantationsschritt ein vergrabenes P Dotierungsgebiet als Kollektorgebiet eines PNP Transistors, in einem anderen Dotierungsschritt ein an die Oberfläche reichendes, auf das P Dotierungsgebiet aufsetzendes P Dotierungsgebiet als Basisgebiet eines NPN Transistors, in einem weiteren Dotierungsschritt ein N Dotierungsgebiet im Basisgebiet des NPN Transistors als Emittergebiet dieses Transistors und durch Aufbringen einer Metallbelegung auf die Oberfläche über dem Kollektorgebiet des PNP Transistors ein Schottky-Kontakt als Emitter dieses Transistors gebildet wird, gekennzeichnet durch folgende Verfahrensschritte:

a) In einem ersten Ionenimplantationsschritt wird mindestens in einem für den PNP Transistor und mindestens in einem für den NPN Transistor bestimmten Bereich des Halbleitermaterials jeweils ein vergrabenes P Dotierungsgebiet (28', 34, 36) erzeugt, wobei das eine das (Sub)Kollektorgebiet (34) des PNP Transistors und das andere das Basisgebiet (36) des NPN Transistors bildet (Fig. 2B).

b) In einem zweiten Implantationsschritt wird in jedem Bereich ein auf das vergrabene P Dotierungsgebiet aufsetzendes und bis an die Oberfläche reichendes P Dotierungsgebiet (28'', 42, 44) erzeugt, wobei das eine das Kollektoranschlußgebiet (42) des PNP Transistors und das andere ein ergänzendes Basisgebiet (44) des NPN Transistors bildet (Fig. 2C).

c) In einem dritten Dotierungsschritt, vorzugsweise einem Ionenimplantationsschritt, mit Dotierstoffen vom N Leitungstyp wird das Basisanschlußgebiet (50) des PNP Transistors und das Emittergebiet (52) des NPN Transistors erzeugt (Fig. 2E).

d) Durch Aufbringen einer Metallbelegung mit einem hohen Austrittsarbeitswert wird beabstandet vom Kollektoranschlußgebiet (42) auf dem Basisgebiet (59) über dem (Sub)Kollektorgebiet (34) des PNP Transistors der den Emitter des PNP Transistors liefernde Schottky-Kontakt (72) gebildet (Fig. 2F).

2. Verfahren nach Anspruch 1, dadurch gekennzeichnet, daß in das Silicium-Halbleitermaterial (32) ein auf dem vergrabenen P Dotierungsgebiet (34) aufsetzendes und bis an die Oberfläche reichendes definiertes Basisgebiet (59) des PNP Transistors eingebracht wird, das eine Oberflächendotierungskonzentration kleiner $10^{17}$ Atome/cm³ aufweist, und daß dann auf die Oberfläche dieses Basisgebiets der Schottky-Kontakt (72) aufgebracht wird.

3. Verfahren nach Anspruch 1 oder 2, dadurch gekennzeichnet, daß das Basis- und/oder Kollektorgebiet des PNP Transistors jeweils in Epitaxieschichtmaterial implantiert werden.

**Revendications**

1. Procédé de fabrication d'un agencement semi-conducteur avec des transistors complémentaires dans un matériau semi-conducteur de silicium de conductivité du type N; dans lequel, au cours d'une étape d'implantation d'ions, une région à dopage P enterrée est formée comme région de collecteur d'un transistor PNP; dans lequel au cours d'une autre étape de dopage, une région à dopage P atteignant la surface et superposée à la région à dopage P, est formée comme étant la région de base d'un transistor NPN; dans lequel, au cours d'une autre étape de dopage, une région à dopage N est formée dans la région de base du transistor NPN comme une région d'émetteur de ce transistor; et dans lequel, par l'application d'un revêtement de métal sur la surface recouvrant la région de collecteur du transistor PNP, un contact à barrière de Schottky est formée comme étant l'émetteur de ce transistor; ce procédé étant caractérisé par les étapes suivantes:

a) au cours d'une première étape d'implantation d'ions, des régions enterrées à dopage P (28', 34, 36) sont formées au moins dans une région du matériau semi-conducteur déterminé pour le transistor PNP, et d'au moins une région déterminée pour le transistor NPN, l'une formant la région de (sous) collecteur (34) du transistor PNP et l'autre, la région de base (36) du transistor NPN (figure 2B),

b) au cours d'une deuxième étape d'implantation d'ions, les régions à dopage P (28", 42, 44) superposées à la région enterrée à dopage P et atteignant la surface, sont formées dans chacune ce ces régions, l'une formant la région de contact de collecteur (42) du transistor PNP et l'autre, une région de base supplémentaire (44) du transistor NPN (figure 2C),

c) au cours d'une troisième étape de dopage, de préférence une étape d'implantation d'ions, avec des dopants de conductivité du type N, on produit les régions de contact de base (50) du transistor PNP et d'émetteur (52) du transistor NPN (figure 2B),

d) par l'application d'un métal à travail de sortie élevé, le contact à barrière de Schottky (72) formant l'émetteur du transistor PNP, est réalisé à une certaine distance de la région de contact de collecteur (42) sur la région de base (59) par dessus la région de (sous) collecteur (34) du transistor PNP (figure 2F).

2. Procédé selon la revendication 1, caractérisé en ce que dans le matériau semi-conducteur de silicium (32), une région de base du transistor PNP (59), superposée à la région à dopage P enterrée (34) et atteignant la surface, est introduite avec une concentration de dopant de surface de moins de $10^{17}$ atomes par cm³, et en ce que, le contact à barrière de Schottky (72) est ensuite formé sur la surface de cette région de base.

3. Procédé selon la revendication 1 ou 2, caractérisé en ce que la région de base et/ou de collecteur du transistor PNP est(sont) respectivement implantées dans le matériau de la couche épitaxiale.

**Claims**

1. Method of making a semiconductor arrangement with complementary transistors in a silicon semiconductor material of the N-type conductivity, where in an ion implantation step a buried P-doping region is formed as a collector region of a PNP transistor, in another doping step a P-doping region reaching to the surface and superimposed on the P-doping region is formed as the base region of an NPN transistor, and where in a further doping step an N-doping region is formed in the base region of the NPN transistor as an emitter region of this transistor, and whereby the application of a metal coating onto the surface over the collector region of the PNP transistor a Schottky barrier contact is formed as the emitter of this transistor, characterized by the following process step:

a) In a first ion implantation step, one respective buried P-doping region (28', 34, 36) is generated at least in one region of the semiconductor material determined for the PNP transistor, and at least in one region determined for the NPN transistor, one forming the (sub)collector region (34) of the PNP transistor, and the other the base region (36) of the NPN transistor (Fig. 2B).

b) In a second implantation step, a P-doping region (28", 42, 44) superimposed on the buried P-doping region and reaching up to the surface is generated in each region, one forming the collector contact region (42) of the PNP transistor, and the other a supplementary base region (44) of the NPN transistor (Fig. 2C).

c) In a third doping step, preferably an ion implantation step, with dopants of N-type conductivity the base contact region (50) of the PNP transistor and the emitter region (52) of the NPN transistor are produced (Fig. 2E).

d) By applying a high work function metal, the Schottky barrier contact (72) providing the emitter of the PNP transistor is formed spaced from the collector contact region (42) on the base region (59) over the (sub)collector region (34) of the PNP transistor (Fig. 2F).

2. Method as claimed in claim 1, characterized in that into the silicon semiconductor material (32) a defined PNP transistor base region (59) which is superimposed on the buried P-doping region (34) and reaches up to the surface is inserted having a surface dopant concentration of less than $10^{17}$ atoms/cm$^3$, and that subsequently onto the surface of this base region the Schottky barrier contact (72) is applied.

3. Method as claimed in claim 1 or 2, characterized in that the base and/or collector region of the PNP transistor are respectively implanted in the epitaxy layer material.

FIG. 1A

FIG. 1B

FIG. 2F

FIG. 2G

FIG. 2 A

FIG. 2 B

FIG. 2 C

FIG. 2 D

FIG. 2 E

FIG. 4

FIG. 3

FIG. 5B

FIG. 5A

FIG. 5C